# EUROPEAN PATENT APPLICATION

(11) **EP 3 961 682 A1**
(43) Date of publication of application: **02.03.2022**
(21) Application number: 21192335.4
(22) Date of filing: 20.08.2021
(51) Int. Cl.: H01L 21/56, B29C 45/14, B29C 45/34, H01L 23/31

(54) **A METHOD OF MANUFACTURING SEMICONDUCTOR DEVICES, AND CORRESPONDING TOOL**

(30) Priority: 24.08.2020 IT 202000020380
(71) Applicant: STMicroelectronics S.r.l., 20864 Agrate Brianza (MB) (IT)
(72) Inventor: ROVITTO, Mr. Marco, I-20134 Milano (IT); MAGNI, Mr. Pierangelo, I-20852 Villasanta (Monza Brianza) (IT); MARCHISI, Mr. Fabio, I-20068 Peschiera Borromeo (Milano) (IT)
(74) Representative: Bosotti, Luciano

(57) **Abstract**

A method of manufacturing semiconductor devices (400) comprises attaching a semiconductor die (404) on a die pad (402) of a leadframe having electrically-conductive formations (406) arranged around the die pad (402), and molding package material (414) onto the semiconductor die (404) attached to said die pad (402).

The step of molding package material (414) comprises:
arranging the semiconductor die (404) attached to the die pad (402) in a molding cavity (408) between complementary first (410a) and second (410b) mold portions,
injecting the package material (414) into the molding cavity (408) via at least one injection channel (412) provided in one of the complementary first (410a) and second (410b) mold portions, and
evacuating air from the molding cavity (408) via at least one air venting channel (418) provided in the other of the complementary first (410a) and second (410b) mold portions.

## Description

### Technical field

The description relates to manufacturing semiconductor devices such as, for instance, integrated circuits (ICs).

### Technological background

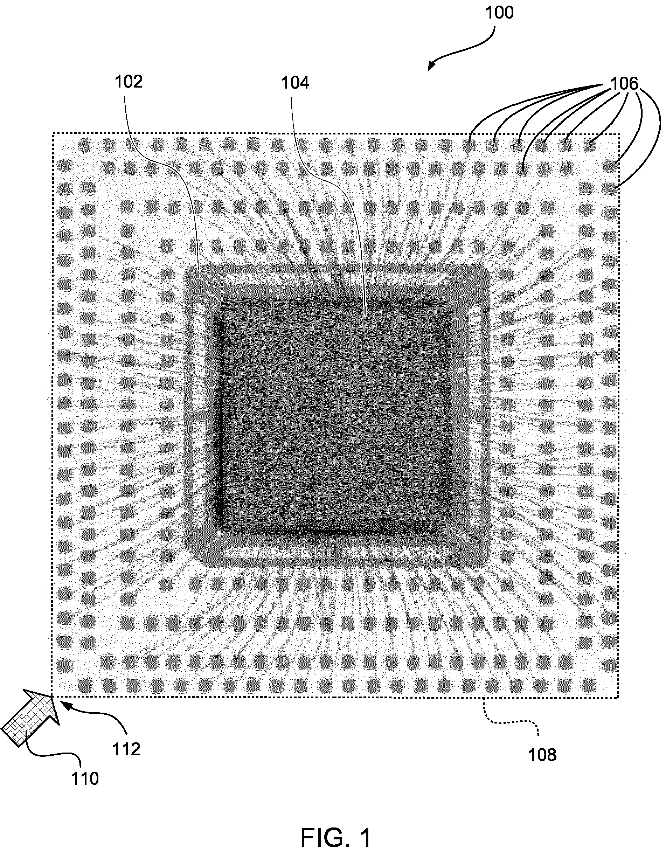

The manufacturing process of integrated circuits conventionally comprises a molding step which aims at encapsulating a semiconductor device in a plastic package to protect it from the outer environment (e.g., from humidity). In that respect, reference may be made to Figure 1 annexed herein.

Figure 1 is a (top) plan view exemplary of certain components of a conventional integrated circuit 100 as known in the art. Purely by way of example, Figure 1 is exemplary of an integrated circuit 100 comprising a package of the type QFN-mr (QFN multi-row).

A conventional integrated circuit 100 as exemplified in Figure 1 comprises a support substrate 102 (e.g., a die pad of a leadframe) having a semiconductor die or chip 104 arranged thereon, e.g., by means of die attach material such as a glue.

The designation "leadframe" (or "lead frame") is currently used (see, for instance, the USPC Consolidated Glossary of the United States Patent and Trademark Office) to indicate a metal frame which provides support for an integrated circuit chip or die as well as electrical leads to interconnect the integrated circuit in the die or chip to other electrical components or contacts.

A conventional integrated circuit 100 as exemplified in Figure 1 further comprises a plurality of electrically-conductive formations 106 (e.g., the leads or the soldering pads of the leadframe, according to the type of package considered) surrounding the support substrate 102 (e.g., arranged radially therearound), and an array of bonding wires arranged between bonding pads provided on the semiconductor die 104 and respective electrically-conductive formations 106.

As exemplified in Figure 1, the support substrate 102, the semiconductor die 104, the bonding wires and at least a portion of the electrically-conductive formations 106 are encapsulated in a plastic material 108 (e.g., an epoxy resin molding compound) which is molded over and around the support substrate 102 and the semiconductor die 104 by injection molding, for instance.

Conventionally, the molding compound is injected at a lateral side or at a corner of the molding cavity defined by a mold (also referred to as package cavity in the present description), as exemplified by arrow 110 in Figure 1 (so-called "side injection"). Therefore, the molding compound flows "sidewise" in the molding cavity (e.g., mainly in a direction which is co-planar with the die pad 102 and/or the semiconductor die 104), which results in the bonding wires being subjected to a deformation from their linearity called "wire sweeping".

As described herein, "wire sweeping" results in the bonding wires being bent in a direction which is substantially co-planar with the die pad 102 and/or the semiconductor die 104, with the molding compound (which flows through the molding cavity from an injection point 112 towards the empty regions of the molding cavity) "dragging" the bonding wires.

The phenomenon of wire sweeping may negatively affect the functionality of the integrated circuit 100. For instance, the bonding wires may be damaged (e.g., broken) or detached from the bonding pads due to the dragging action exerted by the flow of the molding compound, or the bonding wires may come into contact one with another, thereby generating electrical shorts.

As a result, the yield and reliability of the manufacturing process may be negatively affected.

### Object and summary

Despite the activity in the area, improved solutions are desirable. An object of one or more embodiments is to contribute in providing such improved solutions.

According to one or more embodiments, such an object can be achieved by means of a method of manufacturing semiconductor devices having the features set forth in the claims that follow.

One or more embodiments may relate to a molding tool configured for use in such a method.

The claims are an integral part of the technical teaching provided herein in respect of the embodiments.

According to one or more embodiments, a method may comprise attaching at least one semiconductor die on a die pad of a leadframe. The leadframe may comprise an array of electrically-conductive formations around the die pad, and the at least one semiconductor die may have a front surface facing away from the die pad. The front surface of the at least one semiconductor die may have an array of bonding pads for coupling to electrically-conductive formations in the array of electrically-conductive formations of the leadframe. The method may comprise molding package material onto the at least one semiconductor die attached to the die pad.

According to one or more embodiments, molding package material may comprise arranging the at least one semiconductor die attached to the die pad in a molding cavity between complementary first and second mold portions, injecting the package material into the molding cavity via at least one injection channel provided in one of the complementary first and second mold portions, and evacuating air from the molding cavity via at least one air venting channel provided in the other of the complementary first and second mold portions.

One or more embodiments may thus facilitate filling the molding cavity with the molding compound, and countering the formation of voids or air bubbles.

### Brief description of the figures

One or more embodiments will now be described, by way of example only, with reference to the annexed figures, wherein:
Figure 1, which was previously described, is a (top) plan view exemplary of certain components of a conventional integrated circuit,
Figures 2 and 3 are (cross-sectional) side elevation views exemplary of a molding step in the manufacturing process of integrated circuits,
Figures 4 to 9 are (cross-sectional) side elevation views exemplary of possible acts in embodiments, and
Figures 10 and 11 are (cross-sectional) side elevation views exemplary of possible implementation details of one or more embodiments.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The headings/references used herein are provided merely for convenience and hence do not define the extent of protection or the scope of the embodiments.

For simplicity, throughout the figures annexed herein, like parts or elements are indicated with like references/numerals and a corresponding description will not be repeated for brevity.

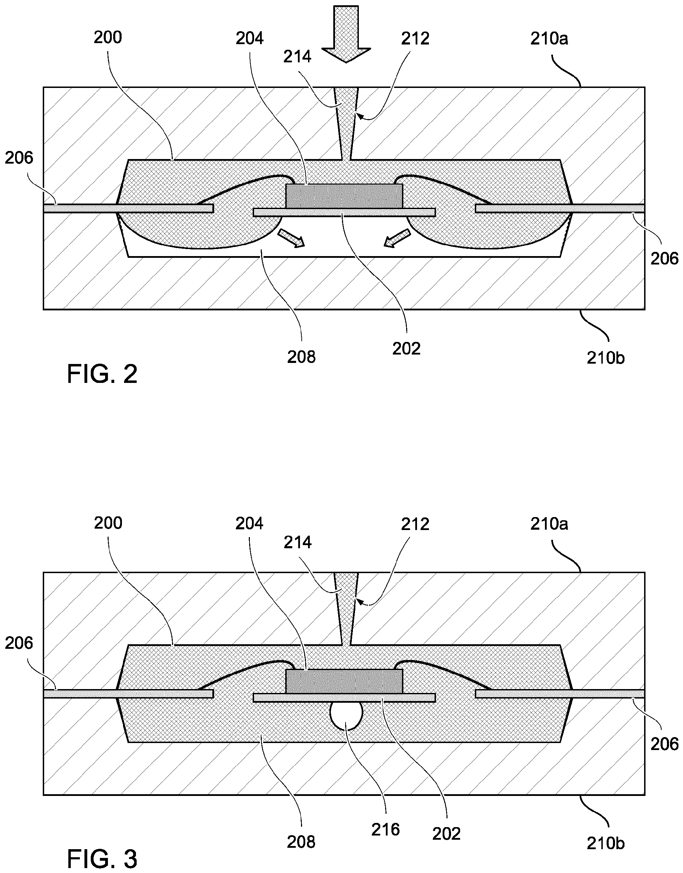

By way of introduction to the detailed description of exemplary embodiments, reference may first be made to Figures 2 and 3, which are exemplary (cross-sectional) elevation side views of a molding step in a process for manufacturing integrated circuits.

The integrated circuits considered herein may comprise a so-called "full plastic" package, i.e., a package where the die pad supporting the semiconductor die (a single semiconductor die is illustrated for the sake of simplicity) is fully encapsulated in the molding compound. In other words, the die pad is not exposed or visible outside of the molding compound.

As conventional in the art, such a molding step may be carried out on a batch of semiconductor devices arranged in an array (e.g., on a common leadframe). Such a common leadframe may be subsequently cut for separating ("singulating") the devices from one another.

As exemplified in Figures 2 and 3, a full plastic package integrated circuit 200 may comprise a die pad 202 having a semiconductor die or chip 204 arranged thereon, e.g., by means of die attach material not visible in the figures. As exemplified herein, the integrated circuit 200 may further comprise a plurality of electrically-conductive formations or leads 206 surrounding the die pad 202 (e.g., arranged radially therearound), and a respective plurality of bonding wires arranged between the bonding pads provided on the semiconductor die 204 and the leads 206.

During the molding step exemplified in Figures 2 and 3, the die pad 202, the semiconductor die 204, the bonding wires and at least a portion of the leads 206 may be arranged in a molding cavity 208 defined by a mold. The mold may comprise a first (e.g., top or upper) shaped mold portion 210a and a second (e.g., bottom or lower) shaped mold portion 210b having a corresponding pair of recessed portions which define the molding cavity 208. As exemplified in Figures 2 and 3, during the molding step the first and second mold portions 210a and 210b are pushed one against the other to close the mold, as conventional in the technique of injection molding.

As exemplified in Figures 2 and 3, one of the first and second mold portions 210a, 210b (here, the first mold portion 210a) is provided with at least one injection channel 212 for each semiconductor device 200 in the array of semiconductor devices (e.g., for each molding cavity 208) . The molding compound 214 is injected into the molding cavity 208 through at least one respective injection channel 212, as exemplified by the arrow in Figure 2.

As exemplified in Figures 2 and 3, the injection channel 212 may be provided as a "top central gate" or "pinnacle gate", i.e., it may be positioned above the semiconductor die 204, approximately at the center of the die pad 202 (which may correspond to the center of the molding cavity 208).

Such "top central gate" injection technology relies on injection of the molding compound 214 taking place from the center of the upper surface of the package (e.g., of the molding cavity 208), thereby reducing the flow of the molding compound 214 in a "lateral" or "sidewise" direction, which would otherwise deform (and possibly damage) the bonding wires already in place. Therefore, such a top central gate injection technology may effectively counter the wire sweeping phenomenon.

While satisfactory when used for the manufacturing of exposed pad packages (i.e., semiconductor packages where the lower surface of the die pad is exposed outside of the package of the semiconductor device, not illustrated herein), a top central gate injection step as exemplified in Figures 2 and 3 may turn out to be unsatisfactory when used for manufacturing full plastic packages as considered herein.

In fact, as exemplified in Figure 3, in a full plastic package the possibility exists that the fronts of the molding compound 214 may join themselves under the die pad 202 entrapping some air. Such entrapped air may fail to evacuate from the molding cavity 208 during solidification of the molding compound 214 (e.g., during a last mold transfer step), resulting in an incomplete filling of the molding cavity 208 and/or entrapped air bubbles 216 (e.g., below the die pad 202).

As used herein, reference to a "last mold transfer step" may relate to a last step of the molding process, wherein the resin which already filled the cavity is subjected to a (last) "compression" to properly pack the material, pushing the air out of the air vents and removing micro air bubbles. However, such a last mold transfer step may not be suitable to effectively push out a relevant air quantity, e.g., as exemplified in Figure 3.

Therefore, one or more embodiments as exemplified in the following may relate to a method of manufacturing a semiconductor device, and a corresponding tool, which facilitate evacuating air from the molding cavity and avoid the formation of entrapped air (e.g., air bubbles) in the molding compound.

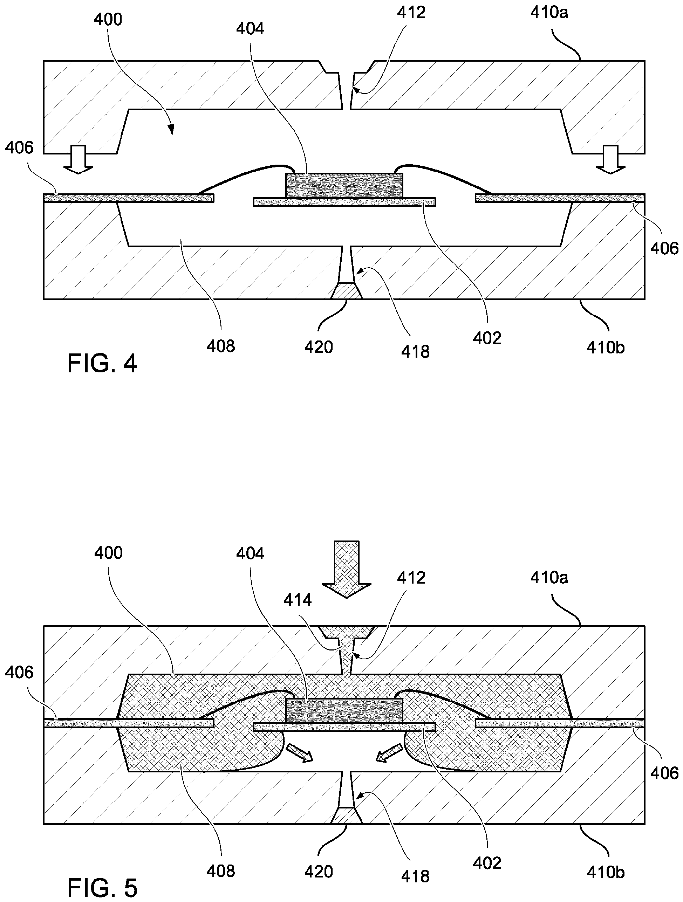

Figures 4 and 5 are exemplary (cross-sectional) elevation side views of a molding step in a manufacturing process of integrated circuits according to one or more embodiments.

As exemplified in Figures 4 and 5, a method of manufacturing a full plastic integrated circuit 400 according to one or more embodiments may comprise providing a leadframe having a die pad 402 and a plurality of electrically-conductive formations (e.g., leads) 406 surrounding the die pad 402 (e.g., arranged radially therearound).

In one or more embodiments, the method may comprise arranging a semiconductor die or chip 404 on the die pad 402 (e.g., by means of die attach material not visible in the figures) and providing a plurality of bonding wires arranged between certain (e.g., selected) bonding pads provided on the semiconductor die 404 and certain (e.g., selected) electrically-conductive formations 406.

As exemplified in Figures 4 and 5, a package molding step may comprise arranging the die pad 402, the semiconductor die 404, the bonding wires and at least a portion of the electrically-conductive formations 406 in a molding cavity 408 defined by a mold. The mold may comprise a first (e.g., top or upper) shaped mold portion 410a having a recessed portion and a second (e.g., bottom or lower) shaped mold portion 410b having a corresponding recessed portion.

During the molding step, the two mold portions 410a and 410b are urged one against the other as conventional in the technique of injection molding, as exemplified by the arrows in Figure 4, to close the mold with the leadframe clamped therebetween and the molding cavity 408 defined by the recessed portions of the first and second mold portions 410a and 410b.

A single semiconductor device 400 is illustrated in Figures 4 to 11 for the sake of simplicity. It will be otherwise understood that a molding step as disclosed herein may be applied to a plurality of semiconductor devices 400 arranged in an array prior to singulation of the semiconductor devices (i.e., prior to cutting the leadframe).

In that case, the shaped mold portions 410a and 410b may comprise a plurality of corresponding recessed portions which define a respective plurality of molding cavities 408.

As exemplified in Figures 4 and 5, one of the first and second mold portions 410a, 410b (here, the first mold portion 410a) is provided with at least one injection channel 412 for each semiconductor device 400 in the array of semiconductor devices. The molding compound 414 is injected into the molding cavity 408 through the respective at least one injection channel 412.

As exemplified in Figures 4 and 5, the at least one injection channel 412 may be provided as a "top central gate" or "pinnacle gate", i.e., it may be positioned above the semiconductor die 404, approximately at the center of the die pad 402 (which typically corresponds to the center of the molding cavity 408). Such "top central gate" injection technology relies on the molding compound 414 being injected from the center of the upper surface of the package (i.e., of the molding cavity 408), thereby reducing the flow of the molding compound 414 in a "lateral" or "sidewise" direction.

As exemplified in Figures 4 and 5, in one or more embodiments the mold portion opposite to the mold portion which comprises the injection channel 412 (here, the second mold portion 410b) may comprise at least one air venting channel 418 (or "dummy gate") configured to collect or evacuate air pushed by the flow of the molding compound 414 during the package molding step (as exemplified by the arrows in Figure 5).

As exemplified in Figures 4 and 5, the at least one air venting channel 418 may be provided as a "bottom central dummy gate", i.e., it may be positioned below the die pad 402, approximately at the center of the die pad 402 (which may correspond to the center of the molding cavity 408). In other words, the venting channel 418 may be positioned at a location which is opposite to the location of the injection channel 412 with respect to the plane defined by the leadframe 402, 406.

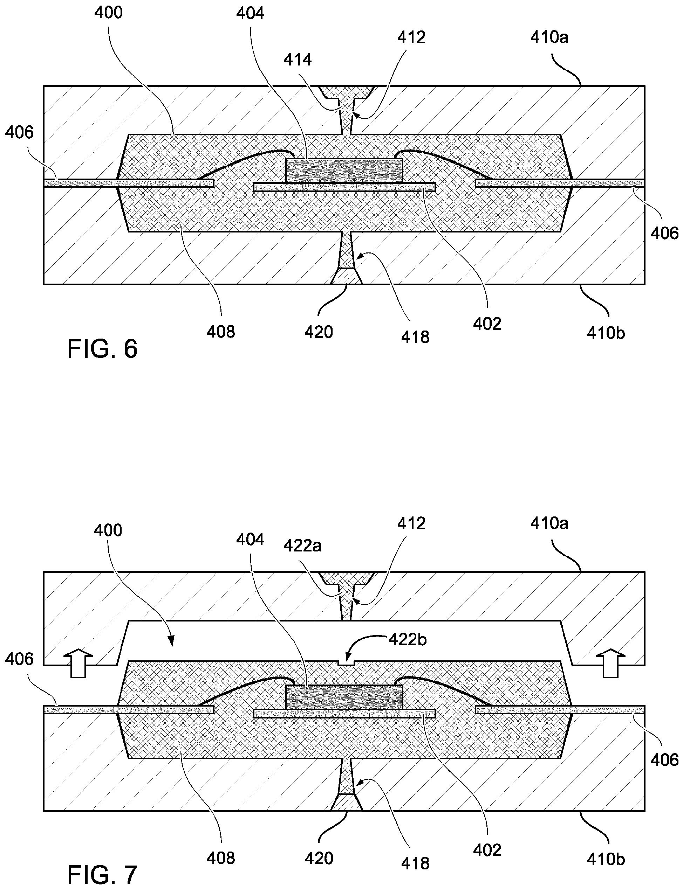

The air venting channel 418 may thus collect air from the molding cavity 408 during a "mold filling" phase of a manufacturing method according to one or more embodiments, facilitating the molding compound 414 to fully occupy the volume of the molding cavity 408 and avoiding the formation of air bubbles in the semiconductor package, as exemplified in Figure 6, which is an exemplary (cross-sectional) elevation side view of a molding step according to one or more embodiments at the end of a "mold filling" phase.

As exemplified in Figure 6, at the end of the mold filling phase the molding compound 414 may occupy the entire volume of the mold cavity 408. Possibly, the molding compound 414 may also occupy at least a portion of the air venting channel 418, depending on the amount of molding material 414 injected into the molding cavity 408. One or more embodiments may comprise injecting into the molding cavity 408 a volume of molding material 414 higher than the volume of the molding cavity 408, e.g., in order to improve the filling of the molding cavity 408.

Therefore, in one or more embodiments a retractable pin 420 may be provided at an end portion of the air venting channel 418 which is opposite to the molding cavity 408. The retractable pin 420 may act as a stopper for the molding compound 414, preventing the molding compound 414 from flowing outside of the molding cavity 408 during the molding step.

As exemplified in Figure 7, one or more embodiments may comprise releasing the first (here upper) mold portion 410a - e.g., moving it away from the second (here lower) mold portion 410b, opening the mold - once the molding compound 414 is solidified. As a result, a top pinnacle or top gate 422a of the solidified molding compound which occupies the volume of the injection channel 412 may be detached from the package of the semiconductor device 400, and a breaking point 422b may be visible on the top surface of the package of the semiconductor device 400 (e.g., at the center thereof).

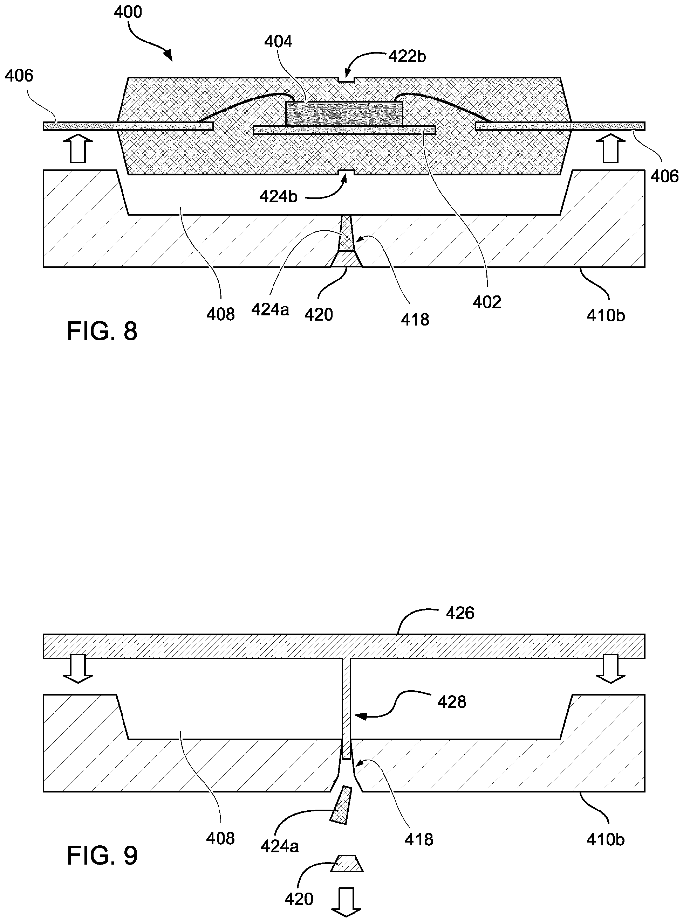

As exemplified in Figure 8, one or more embodiments may comprise releasing (e.g., lifting) the semiconductor device 400 from the lower mold portion 410b (e.g., during a "molded strip lift" phase). As a result, a bottom pinnacle or bottom gate 424a of the solidified molding compound which occupies (at least partially) the volume of the air venting channel 418 may be detached from the package of the semiconductor device 400, and a breaking point 424b may be visible on the lower (e.g., bottom) surface of the package of the semiconductor device 400 (e.g., at the center thereof).

As exemplified in Figure 9, one or more embodiments may comprise retracting the retractable pin 420 from the air venting channel 418, and cleaning the lower mold portion 410b by means of a cleaning arm 426. As exemplified in Figure 9, the cleaning arm 426 may comprise an ejector pin 428 positioned at the air venting channel 418 (e.g., at the center of the molding cavity 408). The cleaning arm 426 may be arranged facing the molding cavity 408 and may be moved towards the lower mold portion 410b so that the ejector pin 428 enters at least partially into the air venting channel 418, causing the detachment of the bottom pinnacle or bottom gate 424a from the lower mold portion 410b.

After the cleaning step exemplified in Figure 9, the mold portions 410a and 410b may be used again for a molding step carried out on another batch of semiconductor devices 400.

In one or more embodiments, the air venting channel 418 may have a tapered shape (e.g., a conical shape), with a smaller cross-section at the end portion which faces the molding cavity 408 and a larger cross-section at the end portion which faces away from the molding cavity 408. Such a tapered shape of the air venting channel 418 may facilitate the cleaning step exemplified in Figure 9, insofar as it may reduce the friction between the bottom pinnacle 424a and the inner walls of the air venting channel 418 while the bottom pinnacle 424a is being ejected from the air venting channel 418.

It is noted that, while possibly not being visible in the figures annexed herein, one or more embodiments may comprise one or more of the alternative and/or additional features discussed in the following.

Additionally or alternatively, in one or more embodiments the at least one injection channel 412 may be provided in the mold portion which faces the back side of the semiconductor device 400 (here, the lower mold portion 410b), i.e., the mold portion which faces the side of the die pad 402 opposite to the semiconductor die 404. The at least one air venting channel 418 may thus be provided in the mold portion which faces the front side of the semiconductor device 400 (here, the upper mold portion 410a), i.e., the mold portion which faces the side of the die pad 402 where the semiconductor die 404 is arranged.

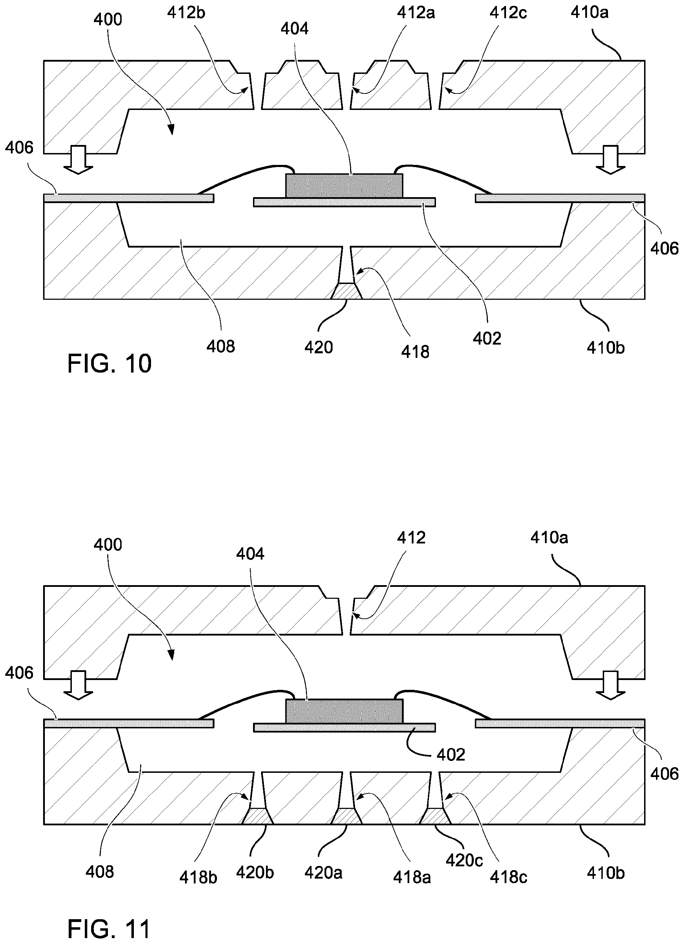

Additionally or alternatively, in one or more embodiments as exemplified in Figure 10 the at least one injection channel may comprise a plurality of injection channels 412a, 412b, 412c for each mold cavity 408 (i.e., for each semiconductor device 400). The injection channels in the plurality of injection channels may not necessarily comprise a "central" injection channel 412a. For instance, an injection channel may be provided at each corner of the die pad 402 (which is typically square or rectangular), or at a subset of said corners, with or without the provision of an injection channel 412a at the center of the die pad 402.

The provision of multiple injection channels, possibly without a central injection channel, may turn out to reduce the "wire sweep" phenomenon.

Additionally or alternatively, in one or more embodiments as exemplified in Figure 11 the at least one air venting channel may comprise a plurality of air venting channels 418a, 418b, 418c for each mold cavity 408 (i.e., for each semiconductor device 400). The air venting channels in the plurality of air venting channels may not necessarily comprise a "central" air venting channel 418a. For instance, an air venting channel may be provided at each corner of the die pad 402 (which is typically square or rectangular), or at a subset of said corners, with or without the provision of an air venting channel 418a at the center of the die pad 402. Accordingly, a plurality of stopping pins 420a, 420b, 420c may be provided, and the cleaning arm 426 may comprise a plurality of ejector pins, e.g., one for each air venting channel 418a, 418b, 418c.

The provision of multiple air venting channels, possibly without a central air venting channel, may turn out to facilitate air evacuation from the molding cavity and improve the filling of the molding cavity.

It is to be understood that, in one or more embodiments, both a plurality of injection channels 412a, 412b, 412c and a plurality of air venting channels 418a, 418b, 418c may be provided (e.g., with one venting channel corresponding to one injection channel), e.g., the embodiments exemplified in Figures 10 and 11 may be combined together.

One or more embodiments may thus facilitate filling the molding cavity 408 with the molding compound 414, with formation of voids or air bubbles effectively countered, insofar as air is forced to flow through at least one air venting channel 418 during the package molding step, while at the same time reducing the phenomenon of bonding wires sweep.

Providing a better control of the bonding wires sweep phenomenon may facilitate manufacturing semiconductor devices having a complex wire bonding pattern. This may turn out to be advantageous, for instance, in the case of full plastic packages with high pins count and/or fine pitch wiring, and/or in the case of full plastic packages comprising a large die pad.

As exemplified herein, a method of manufacturing semiconductor devices (e.g., 400) may comprise:
attaching (e.g., by means of a die attach material such as a glue) at least one semiconductor die (e.g., 404) on a die pad (e.g., 402) of a leadframe, the leadframe comprising an array of electrically-conductive formations (e.g., 406) around said die pad, wherein the at least one semiconductor die has a front surface facing away from said die pad, said front surface having an array of bonding pads for coupling to electrically-conductive formations in said array of electrically-conductive formations of said leadframe, and
molding package material (e.g., 414), for instance an epoxy resin, onto said at least one semiconductor die attached to said die pad.

As exemplified herein, an act of molding package material may comprise:
arranging said at least one semiconductor die attached to said die pad in a molding cavity (e.g., 408) between complementary first (e.g., 410a) and second (e.g., 410b) mold portions,
injecting said package material into said molding cavity via at least one injection channel (e.g., 412) provided in one of said complementary first and second mold portions, and
evacuating air from said molding cavity via at least one air venting channel (e.g., 418) provided in the other of said complementary first and second mold portions.

As exemplified herein, one or more embodiments may comprise electrically coupling (e.g., providing bonding wires) selected ones of said bonding pads in said array of bonding pads to selected ones of said electrically-conductive formations in said array of electrically-conductive formations.

As exemplified herein, a method may comprise arranging in said molding cavity said at least one semiconductor die attached to said die pad with said at least one semiconductor die facing said at least one injection channel and said die pad facing said at least one air venting channel.

As exemplified herein, a method may comprise arranging in said molding cavity said at least one semiconductor die attached to said die pad with said at least one semiconductor die facing said at least one air venting channel and said die pad facing said at least one injection channel.

As exemplified herein, a method may comprise injecting said package material into said molding cavity via an injection channel positioned centrally of said molding cavity.

As exemplified herein, a method may comprise injecting said package material into said molding cavity via a plurality of injection channels.

As exemplified herein, a method may comprise evacuating air from said molding cavity via an air venting channel positioned centrally of said molding cavity.

As exemplified herein, a method may comprise evacuating air from said molding cavity via a plurality of air venting channels.

As exemplified herein, a method may comprise injecting into said molding cavity a volume of said package material higher than a volume of said molding cavity.

As exemplified herein, a method may comprise at least partially obstructing (e.g., via a stopping pin 420) said at least one air venting channel to counter outflow of said package material from said molding cavity.

As exemplified herein, a method may comprise:
releasing from said molding cavity said at least one semiconductor die attached to said die pad having said package material molded thereon, and
removing (e.g., via an ejector tool 426, 428) residual package material (e.g., 424a) from said at least one air venting channel.

As exemplified herein, a molding tool may comprise complementary first and second mold portions couplable to define a molding cavity configured to receive at least one semiconductor die attached to a die pad of a leadframe. The molding tool may further comprise:
at least one injection channel in one of said complementary first and second mold portions, the at least one injection channel configured to inject into said molding cavity package material for said at least one semiconductor die attached to said die pad, and
at least one air venting channel in the other of said complementary first and second mold portions, the at least one air venting channel configured to vent air from said molding cavity during injection of said package material into said molding cavity.

As exemplified herein, said at least one air venting channel may have a tapered shape having a smaller cross-section at an end portion of the at least one air venting channel which faces said molding cavity and a larger cross-section at an end portion of the at least one air venting channel which faces away from said molding cavity.

Without prejudice to the underlying principles, the details and embodiments may vary, even significantly, with respect to what has been described by way of example only, without departing from the extent of protection.

The extent of protection is determined by the annexed claims.

## Claims

1. A method, comprising:
attaching at least one semiconductor die (404) on a die pad (402) of a leadframe, the leadframe comprising an array of electrically-conductive formations (406) around said die pad (402), wherein the at least one semiconductor die (404) has a front surface facing away from said die pad (402), said front surface having an array of bonding pads for coupling to electrically-conductive formations (406) in said array of electrically-conductive formations (406) of said leadframe, and
molding package material (414) onto said at least one semiconductor die (404) attached to said die pad (402),
wherein said molding package material (414) comprises:
arranging said at least one semiconductor die (404) attached to said die pad (402) in a molding cavity (408) between complementary first (410a) and second (410b) mold portions,
injecting said package material (414) into said molding cavity (408) via at least one injection channel (412) provided in one of said complementary first (410a) and second (410b) mold portions, and
evacuating air from said molding cavity (408) via at least one air venting channel (418) provided in the other of said complementary first (410a) and second (410b) mold portions.

2. The method of claim 1, comprising arranging in said molding cavity (408) said at least one semiconductor die (404) attached to said die pad (402) with said at least one semiconductor die (404) facing said at least one injection channel (412) and said die pad (402) facing said at least one air venting channel (418).

3. The method of claim 1, comprising arranging in said molding cavity (408) said at least one semiconductor die (404) attached to said die pad (402) with said at least one semiconductor die (404) facing said at least one air venting channel (418) and said die pad (402) facing said at least one injection channel (412).

4. The method of any of the previous claims, comprising injecting said package material (414) into said molding cavity (408) via an injection channel (412) positioned centrally of said molding cavity (408).

5. The method of any of the previous claims, comprising injecting said package material (414) into said molding cavity (408) via a plurality of injection channels (412a, 412b, 412c).

6. The method of any of the previous claims, comprising evacuating air from said molding cavity (408) via an air venting channel (418) positioned centrally of said molding cavity (408).

7. The method of any of the previous claims, comprising evacuating air from said molding cavity (408) via a plurality of air venting channels (418a, 418b, 418c).

8. The method of any of the previous claims, comprising injecting into said molding cavity (408) a volume of said package material (414) higher than a volume of said molding cavity (408).

9. The method of any of the previous claims, comprising at least partially obstructing (420) said at least one air venting channel (418) to counter outflow of said package material (414) from said molding cavity (408) .

10. The method of any of the previous claims, comprising:
releasing from said molding cavity (408) said at least one semiconductor die (404) attached to said die pad (402) having said package material (414) molded thereon, and
removing residual package material (424a) from said at least one air venting channel (418).

11. A molding tool, comprising complementary first (410a) and second (410b) mold portions couplable to define a molding cavity (408) configured to receive at least one semiconductor die (404) attached to a die pad (402) of a leadframe, wherein said molding tool comprises:
at least one injection channel (412) in one of said complementary first (410a) and second (410b) mold portions, the at least one injection channel (412) configured to inject into said molding cavity (408) package material (414) for said at least one semiconductor die (404) attached to said die pad (402), and
at least one air venting channel (418) in the other of said complementary first (410a) and second (410b) mold portions, the at least one air venting channel (418) configured to vent air from said molding cavity (408) during injection of said package material (414) into said molding cavity (408).

12. The molding tool of claim 11, wherein said at least one air venting channel (418) has a tapered shape having a smaller cross-section at an end portion of the at least one air venting channel (418) which faces said molding cavity (408) and a larger cross-section at an end portion of the at least one air venting channel (418) which faces away from said molding cavity (408).
